# FASCICULE DE BREVET EUROPEEN

(11) **EP 2 819 068 B1**
(45) Date de publication et mention de la délivrance du brevet: **03.08.2022**
(21) Numéro de dépôt: 14173939.1
(22) Date de dépôt: 25.06.2014
(51) Int. Cl.: G06N 3/04, G06N 3/063, G11C 11/54, G11C 13/00

(54) **Neurone artificiel comprenant une memoire resistive**
Künstliches Neuron, das einen resistiven Speicher umfasst
Artificial neuron including a resistive memory

(30) Priorité: 26.06.2013 FR 1356143
(43) Date de publication de la demande: 31.12.2014
(73) Titulaire: COMMISSARIAT À L'ÉNERGIE ATOMIQUE ET AUX ÉNERGIES ALTERNATIVES, 75015 Paris (FR)
(72) Inventeur: Suri, Manan, 38000 Grenoble (FR); Palma, Giorgio, 38000 Grenoble (FR)
(74) Mandataire: Marks & Clerk France

(56) Documents cités:
- S. SHIN ET AL: "Neuronal spike event generation by memristors", PROCEEDINGS OF THE 13TH INTERNATIONAL WORKSHOP ON CELLULAR NANOSCALE NETWORKS AND THEIR APPLICATIONS (CNNA'12), 29 août 2012 (2012-08-29), XP032253872, DOI: 10.1109/CNNA.2012.6331427
- J. Grollier et al: "MemCo worksop invited speakers slides & posters (source, w/ indexes)", Workshop on Memristors for Computing (MemCo): 19-21 November 2012, 20 novembre 2012 (2012-11-20), XP055110633, Extrait de l'Internet: URL:http://www.trt.thalesgroup.com/ump-cnr s-thales/memco/slides.htm [extrait le 2012-12-09]
- M. Suri: "Emerging resistive memory technology for neuromorphic systems and applications", Thèse de doctorat de l'université de Grenoble, 18 septembre 2013 (2013-09-18), XP055110630, Extrait de l'Internet: URL:http://tel.archives-ouvertes.fr/tel-00 935190 [extrait le 2014-01-24]

## Description

L'invention concerne un neurone artificiel comprenant une mémoire résistive. Elle s'applique au domaine des réseaux de neurones artificiels et de l'informatique cognitive. Ces réseaux sont schématiquement inspirés des réseaux de neurones biologiques dont ils imitent le fonctionnement.

Le domaine technique des réseaux de neurones et de l'informatique cognitive gagne en importance ces dernières années. Des applications potentielles sont à l'étude notamment pour la robotique, l'analyse de données à grande échelle et des systèmes autonomes intelligents et le calcul bioinspirés. Les réseaux de neurones artificiels sont composés essentiellement de neurones interconnectés entre eux par des synapses. Les synapses sont habituellement mises en oeuvre par des mémoires numériques ou des composants résistifs dont la conductance varie en fonction de la tension ou du courant appliquée à leurs bornes.

Deux techniques connues peuvent être utilisées pour mettre en œuvre la stochasticité dans les systèmes neuromorphiques. Elles sont décrites dans l'article de M.Suri et al. intitulé CBRAM devices as binary synapses for lowpower stochastic neuromorphic systems: Auditory (Cochlea) and visual (Retina) cognitive processing applications, International Electron Devices Meeting (IEDM) pp.10.3.1-10.3.4 (2012),.

La première technique consiste à introduire la stochasticité à l'aide de circuits générateurs de nombres aléatoires PRNG (Pseudo-Random Noise Generator). Ces circuits occupent grande surface de silicium et sont complexes à concevoir. Ainsi, si le nombre de synapses et de neurones dans le réseau neuronal est élevé, une grande partie de la surface de la puce électronique mettant en œuvre le système neuromorphique sera consacrée à la mise en œuvre de circuits générateurs de nombres aléatoires externes. En effet, un grand nombre de transistors est nécessaire à la mise en œuvre des différentes portes logiques des circuits PNRG. Si les circuits générateurs de nombres aléatoires sont mis en œuvre à l'extérieur de la puce électronique du système neuromorphique, le phénomène de dissipation de puissance peut alors devenir important.

La deuxième technique utilise les propriétés physiques de dispositifs à base de mémoires résistives utilisés pour la mise en œuvre des synapses. Le principal inconvénient de cette deuxième technique est son manque de flexibilité. Les conditions de programmation utilisées pour obtenir une commutation d'un état à un autre intrinsèque probabiliste ou stochastique dépendent de la technologie et des matériaux utilisés pour fabriquer les dispositifs synaptiques. Ainsi, si des dispositifs de type CBRAM (Conductive-Bridge Random Access Memory) sont choisis, leurs conditions de programmation intrinsèques ne pourront pas être réutilisées pour une autre technologie synaptique. De plus, les dispositifs synaptiques peuvent se dégrader lorsqu'ils sont utilisés fréquemment. En conséquence, leurs conditions de programmation peuvent changer au cours du temps.

En 2012, Shin et al. (Neuronal spike event génération by memristors ; Actes de CNNA'12 ; DOI:10.1109/CNNA.2012.6331427) décrivirent la réalisation de générateurs d'impulsion ainsi que leur utilisation dans des réseaux de neurones à impulsion.

Un des buts de l'invention est notamment de remédier aux inconvénients précités.

A cet effet l'invention a pour objet un circuit pour la mise en œuvre d'un neurone artificiel, selon la revendication indépendante 1.

Des modes de réalisation préférés sont définis dans les revendications dépendantes 2 à 7.

D'autres caractéristiques et avantages de l'invention apparaîtront à l'aide de la description qui suit donnée à titre illustratif et non limitatif, faite en regard des dessins annexés parmi lesquels :
- la figure 1 représente un synoptique fonctionnel d'un réseau de neurones artificiel selon l'art antérieur ;
- la figure 2 donne un exemple de système neuromorphique
- la figure 3 illustre schématiquement le principe d'un dispositif neuronal de type LIF ;
- la figure 4 présente de manière simplifiée l'architecture d'un neurone artificiel de type S-LIF ;
- la figure 5 illustre les deux états d'une mémoire résistive de type CBRAM ainsi que la dispersion des valeurs de résistance associées à ces états ;
- la figure 6a illustre schématiquement une mémoire CBRAM après que le filament se soit cassé ;
- la figure 6b représente la distribution de probabilité de la hauteur restante h du filament après rupture exprimée en nanomètres ;
- la figure 6c représente la distribution de probabilité du temps Tset de passage de l'état de haute résistance à l'état de basse résistance exprimé en millisecondes pour une tension V appliquée aux bornes de la mémoire résistive CBRAM ;
- la figure 6d représente la distribution de probabilité de la tension Vset appliquée aux bornes de la mémoire résistive CBRAM pour la faire commuter dans un temps t ;
- la figure 7 donne un exemple de circuit mettant en œuvre un neurone artificiel de type S-LIF ;
- la figure 8 illustre le fonctionnement stochastique d'un neurone S-LIF ;
- la figure 9 comprend cinq courbes présentant chacune une succession d'impulsions de sortie d'un neurone artificiel ;
- la figure 10 représente un exemple de circuit mettant en œuvre un neurone artificiel de type S-LIF utilisant une mémoire résistive unipolaire.

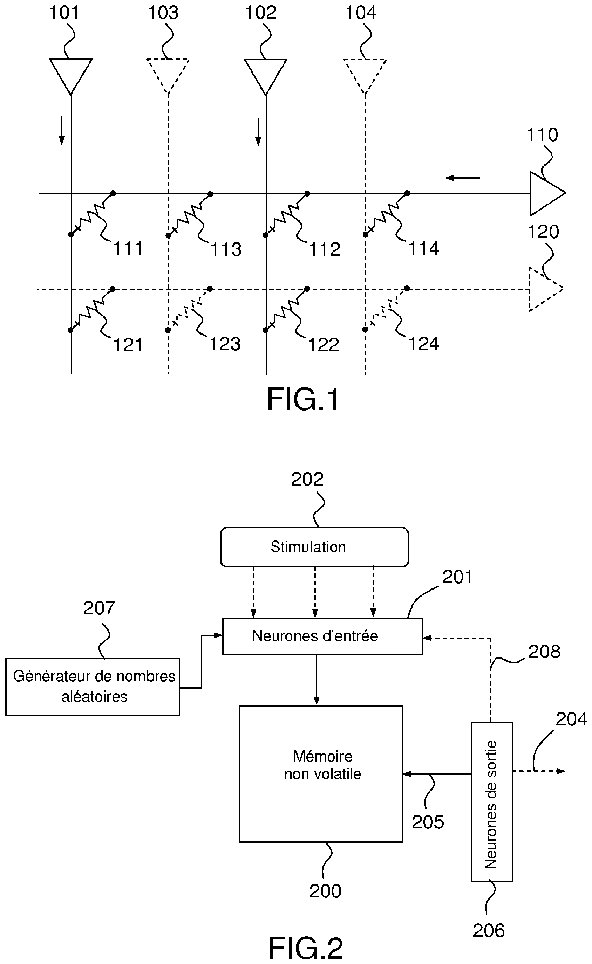

La figure 1 représente un synoptique fonctionnel d'un réseau de neurones artificiel selon l'art antérieur.

Une pluralité de neurones d'entrée 101, 102, 103, 104 sont connectés à une pluralité de neurones de sortie 110, 120 par l'intermédiaire d'une pluralité de synapses artificielles 111, 112, 113, 114, 121, 122, 123, 124. Une synapse artificielle peut être réalisée au moyen d'un dispositif memristif appelée aussi mémoire résistive dont la conductance G varie en fonction du courant ou de la tension appliquée à ses bornes. Une synapse 111 a l'un de ses deux terminaux connecté à un neurone d'entrée 101 et l'autre terminal connecté à un neurone de sortie 110. Un neurone artificiel est un composant actif qui peut présenter simultanément ou séparément les fonctions de neurone d'entrée et/ou de neurone de sortie. Un neurone artificiel est appelé neurone d'entrée lorsqu'il est connecté en aval d'une synapse et neurone de sortie lorsqu'il est connecté en amont d'une synapse. Les neurones artificiels peuvent être actifs ou inactifs. Sur la figure 1, à titre d'exemple, les neurones d'entrée 101, 102 sont considérés actifs et les neurones d'entrée 103, 104 inactifs. De même le neurone de sortie 110 est actif alors que le neurone de sortie 120 est inactif. Un neurone est actif lorsqu'à l'instant considéré, il émet une impulsion. La durée de son état « actif » peut être prédéterminée.

La figure 2 donne un exemple de système neuromorphique.

Un tel système peut être implémenté sur un unique circuit dédié, sur un circuit programmable ou en utilisant une combinaison des deux. Ainsi certaines parties peuvent être mises en œuvre par logiciel et d'autres à l'aide d'architectures dédiées.

Ce système se compose de quatre blocs principaux. Un premier bloc 200 met en œuvre une matrice mémoire non volatile ou une mémoire de type « crossbar ».

Un bloc 201 comprenant des neurones d'entrée est utilisé pour la génération de signaux d'entrée qui seront injectés dans le bloc de mémoire 200. Différents types de modèles de neurones peuvent être utilisés. A titre d'exemple, des neurones de type LIF « Leaky Integrate-and-Fire » peuvent être utilisés. D'autres types de neurones artificiels comme par exemple les neurones S-LIF (Stochastically-firing LIF) peuvent être avantageusement utilisés.

Les neurones d'entrées peuvent être stimulés par un bloc 202 générant des signaux de stimulation habituellement désignés par le mot anglais « spikes ». Ce bloc émule par exemple l'oreille interne et en particulier la cochlée. D'autres applications pouvant être également considérées. Un autre exemple est d'utiliser une rétine artificielle comme bloc de stimulation 202. De manière plus générale, le bloc 202 peut être une source de tout type de données numériques ou analogiques, asynchrones ou synchrones utilisées comme entrée pour effectuer une reconnaissance de formes, de classification de motifs ou de traitement du signal. Ce modèle peut être fondé sur un modèle biologique.

Un bloc 206 comprenant des neurones de sortie est utilisé pour générer les signaux de sortie 204 du système neuromorphique. Ces neurones génèrent dans certains cas des signaux 205, 208 permettant de mettre en œuvre un apprentissage par la matrice de mémoire comprenant les synapses.

Un générateur de nombres aléatoires 207 peut être utilisé dans le but d'implémenter dans une partie du circuit mémoire tout type de règle d'apprentissage probabiliste ou stochastique, comme par exemple une règle STDP.

La complexité des blocs de neurones 201 dépend de la fonctionnalité implémentée dans le réseau de neurones et des modèles biologiques choisis pour le programmer. Des dispositifs neuronaux notamment de type LIF ou S-LIF peuvent être utilisés pour la mise en œuvre du bloc 201.

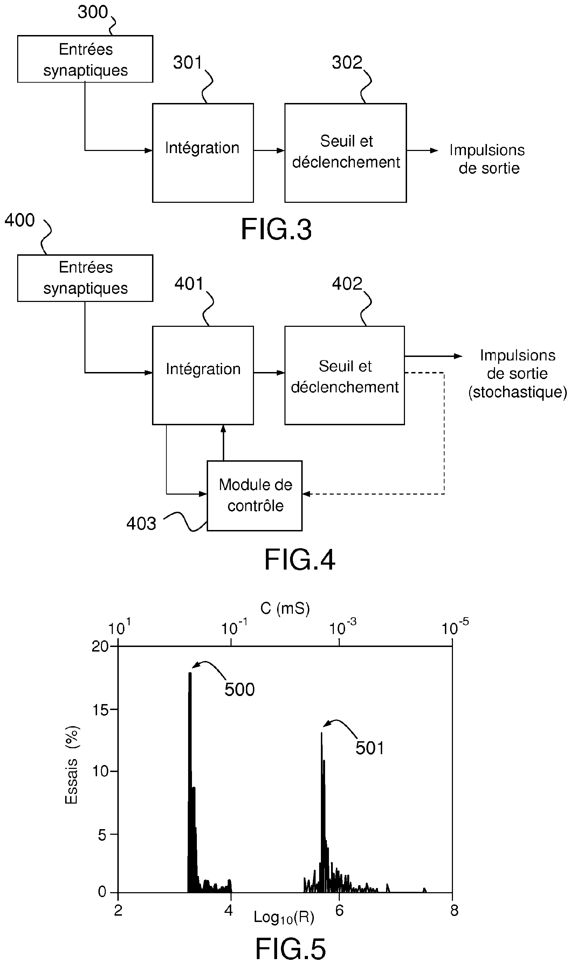

La figure 3 illustre schématiquement le principe d'un dispositif neuronal de type LIF.

Des signaux électriques provenant par exemple des synapses d'un 300 passent par un intégrateur 301 dont la fonction est de sommer les entrées synaptiques ou courants entrants à l'aide de composants tels que des condensateurs. Cette intégration conduit à une augmentation du potentiel de la membrane du neurone.

Un bloc 302 de détection à seuil est également utilisé. Lorsque le potentiel de la membrane atteint une valeur de seuil prédéfinie, le neurone de sortie génère une impulsion de sortie. Après que le neurone ait tiré, c'est-à-dire qu'il ait généré une telle impulsion de sortie, le potentiel de membrane remonte à une valeur de repos appelé état initial.

Un neurone LIF fonctionne de manière déterministe. En effet, une impulsion de sortie est émise dès que le potentiel de membrane atteint une valeur de seuil prédéfinie.

Dans la suite de la description, un nouveau type de neurone artificiel appelé neurone LIF à déclenchement stochastique est décrit. Ce type de neurone peut être désigné en utilisant l'acronyme S-LIF (stochastically firing LIF).

La figure 4 présente de manière simplifiée l'architecture d'un neurone artificiel de type S-LIF.

Un neurone artificiel de type S-LIF peut recevoir en entrée des signaux électriques provenant par exemple de synapses. Comme pour le cas d'un neurone de type LIF, un neurone de type S-LIF comprend un intégrateur 401 et un bloc 402 de détection à seuil et de génération d'impulsion de sortie. En outre, il comprend un module 403 de contrôle stochastique.

Ce type de neurone artificiel permet d'obtenir un déclenchement stochastique des impulsions de sortie. Pour cela, le déclenchement du neurone, c'est-à-dire la génération d'une impulsion de sortie, n'est pas parfaitement synchronisé avec l'instant où la valeur de seuil Vth est dépassée par la tension du signal de l'intégration. En effet, une impulsion de sortie est générée après un retard Tset correspondant au temps nécessaire pour faire basculer la mémoire résistive avec une tension donnée, la valeur de ce retard variant d'une émission d'impulsion de sortie à l'autre en fonction d'une distribution de probabilité donnée. Pour cela, un module 403 de contrôle stochastique du neurone associé à cette distribution peut être avantageusement utilisé. Ce module peut être mis en œuvre grâce à une mémoire résistive, ce type de mémoire comprenant des propriétés de commutation stochastique.

La technologie CBRAM aussi appelée PMC (Programmable Metallization Cell) ou EMC (Electrochemical Metallization Cell) est prise comme exemple de mémoire résistive dans la suite de la description, mais l'invention est aussi applicable à d'autres types de mémoires résistives à technologies nanométriques, comme par exemple les technologies PCM (Phase Change Memory) ou OXRAM « Oxide Based Memory ». Elle peut en outre être appliquée à des mémoires magnétiques comme les MRAM (Magnetoresistive Random-Access Memory) ou à des mémoires STT-RAM (Spin-Transfer Torque Random Access Memory).

La figure 5 illustre les deux états d'une mémoire résistive de type CBRAM ainsi que la dispersion des valeurs de résistance associées à ces états.

Les abscisses de cette figure correspondent au logarithme en base 10 de la résistance de la mémoire CBRAM. La valeur de conductance C exprimée en millisiemens (mS) et également indiquée. Les ordonnées correspondent au pourcentage d'essais de commutation de la mémoire résistive ayant permis d'obtenir une valeur de résistance donnée.

Le principe de ce type de mémoire résistive s'appuie sur la formation d'un filament conducteur permettant une transition entre un état bas et un état haut de résistance. Une mémoire résistive CBRAM est de type bipolaire car une tension positive doit être appliquée à ses bornes pour obtenir l'état bas de résistance et une tension négative pour obtenir l'état haut de résistance. Cependant, les valeurs de résistance obtenues après avoir commuté la mémoire d'un état à l'autre ne sont pas toujours les mêmes. La figure 5 montre deux pics 500, 501 correspondant respectivement aux valeurs de résistance associée aux états bas et haut. L'existence d'un phénomène de dispersion des valeurs de résistance au voisinage de ces deux pics 500, 501 est révélée par cette figure. En effet, d'autres valeurs de résistance peuvent être obtenues que celles associées aux deux pics principaux 500, 501 du fait de l'existence de pics secondaires dispersés autour desdits deux pics principaux. Ainsi, cela montre que la commutation de l'état haut vers l'état bas et contraire n'est pas entièrement déterministe car deux distributions statistiques apparaissent au voisinage des deux pics principaux 500, 501.

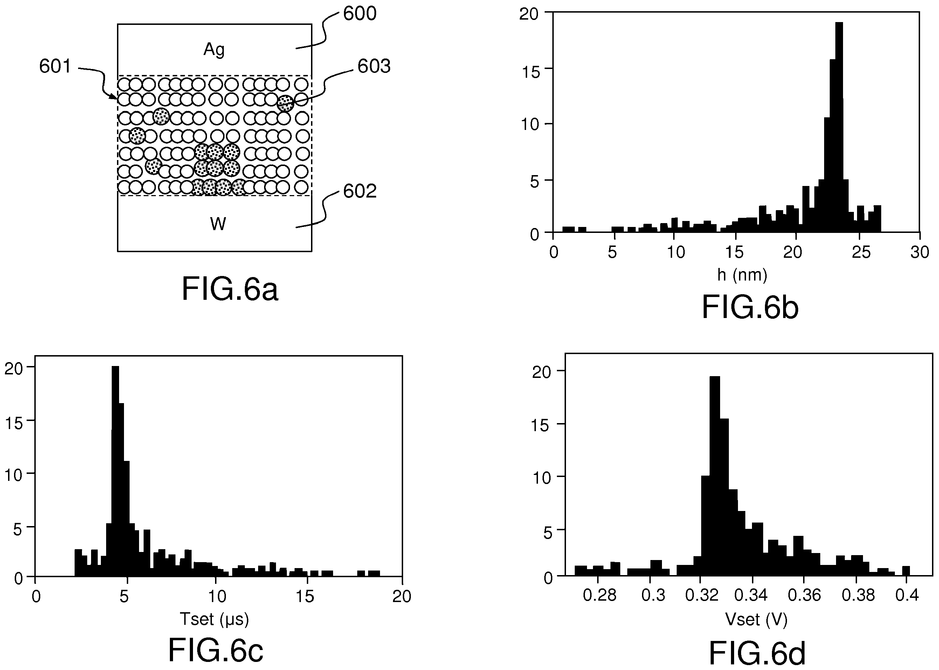

La figure 6a illustre schématiquement une mémoire CBRAM après que le filament se soit cassé. Une mémoire résistive de type CBRAM possède une électrode en métal actif électrochimiquement comme de l'argent (Ag) 600. Du cuivre (Cu) peut être également utilisé pour mettre en œuvre cette électrode. Des ions Ag+ de grande mobilité dérivent dans une couche conductrice 601, par exemple en sulfure de germanium (GeS2), et sont réduits au niveau d'une cathode 602 par exemple en tungstene (W). Cela conduit à la croissance de dendrites Ag 603, c'est-à-dire à la constitution d'un filament à haute conductivité. Lorsque ce filament existe, le circuit CBRAM est dans un état de basse résistance. En effet, la résistance R du circuit est alors très faible. Par conséquent, sa conductance G=1/R est très élevée.

Lorsqu'une inversion de polarité de tension est appliquée aux bornes de la cellule CBRAM, une dissolution électrochimique du pont conducteur se produit et le circuit est alors en état de haute résistance. On parle alors de réinitialisation du système. En en état de haute résistance, la résistance du circuit est élevée et par conséquent sa conductance G=1/R est faible.

Le passage de l'état de basse résistance à l'état de haute résistance est rendu possible grâce au contrôle de la rupture du filament. Cependant, il apparaît qu'une portion du filament peut subsister. Une telle portion de hauteur h est représentée sur la figure 6a. Ce phénomène introduit un caractère stochastique dans le comportement de la mémoire CBRAM lors du passage vers l'état de haute résistance.

Les figures 6b, 6c et 6d correspondent à trois distributions statistiques de paramètres physiques d'une mémoire résistive CBRAM. Ces distributions ont été calculées après avoir déclenché la commutation de l'état de haute résistance vers l'état de basse résistance, c'est-à-dire après avoir appliqué la tension ou le courant adapté pour que le filament de la mémoire résistive soit créé à partir d'une hauteur initiale du filament conducteur génère en façon stochastique pendant la phase du RESET.

La figure 6b représente la distribution de probabilité de la hauteur restante h du filament après rupture exprimée en nanomètres (nm).

La figure 6c représente la distribution de probabilité du temps Tset de passage de l'état de basse résistance à l'état de haute résistance exprimé en microsecondes (µs).

La figure 6d représente la distribution de probabilité de la tension Vset appliquée aux bornes de la mémoire résistive CBRAM.

Il apparaît que la commutation d'un état vers un autre n'est pas parfaitement déterministe notamment pour le cas des mémoires résistives de type CBRAM ou PMC ou EMC mais également pour d'autres types de mémoires résistives, notamment les mémoires, PCM, OXRAM, MRAM ou STT-RAM.

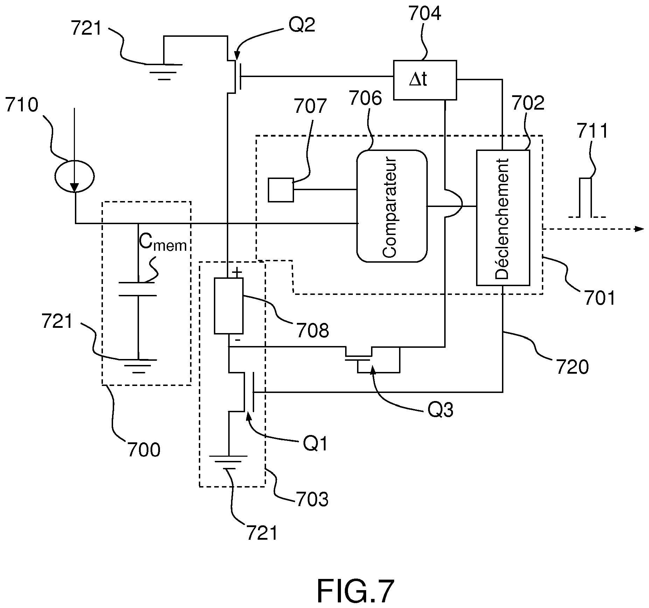

La figure 7 donne un exemple de circuit mettant en œuvre un neurone artificiel de type S-LIF.

L'architecture présentée se compose de plusieurs blocs fonctionnels. Certains blocs peuvent se retrouver dans des architectures de neurones artificiels classiques de type LIF. Une source de courant 710 est représentée et correspond au courant d'entrée injecté par le réseau synaptique dans le neurone artificiel. Le circuit comprend également un bloc d'intégration 700 composé d'un condensateur Cmem relié à la masse. Un bloc 701 joue le même rôle que le bloc 402. Il peut être mis en œuvre par exemple à l'aide d'un comparateur de tensions 706. La tension Vmem de sortie du bloc d'intégration 700 est comparée avec une tension seuil Vth. La tension seuil Vth peut-être générée par un générateur de tension 707. Le comparateur 706 génère un signal de déclenchement lorsque la tension Vmem dépasse la tension seuil Vth. Ce signal de déclenchement correspond par exemple à un signal binaire comprenant deux états '0' et '1'. Ledit signal est transmis à un générateur d'impulsion de sortie 702 qui produit une impulsion 711 à chaque fois que signal de déclenchement est transmis avec par exemple l'état 1. Ce signal de sortie peut être ensuite injecté dans une couche de synapse d'un système neuromorphique. Il apparaît que les différents blocs composant l'architecture d'un neurone artificiel de type LIF se retrouvent dans cet exemple de neurone artificiel de type S-LIF. Le circuit comprend également un bloc 703 composé d'une mémoire résistive 708 et d'un transistor Q1. Ce transistor est par exemple de type MOSFET (Metal-Oxide-Semiconductor Field-Effect Transistor). L'homme du métier peut aisément choisir de manière alternative d'autres technologies permettant de mettre en œuvre une fonction de type interrupteur ou de sélecteur. D'autres types de transistors que des MOSFET peuvent notamment être utilisés pour cela.

La mémoire résistive 708 est reliée à la ligne de tension Vmem d'une part et au transistor Q1 d'autre part.

Initialement, la mémoire résistive 708 est placée dans son état de haute résistance. Le courant d'entrée en provenance des synapses entre dans le neurone artificiel. Cela a pour conséquence de faire augmenter la charge du condensateur Cmem et donc d'augmenter la tension Vmem. Lorsque la tension Vmem atteint la valeur seuil Vth, le comparateur 706 génère alors un signal de déclenchement et une impulsion de sortie 711 est alors produite 702. En parallèle de l'impulsion de sortie est générée une impulsion de tension Vout 720 permettant de contrôler le transistor Q1 et appelée impulsion de contrôle de la commutation vers l'état de basse résistance. Lorsque la tension Vout est appliquée au niveau de la grille du transistor Q1, celui-ci joue le rôle d'un interrupteur en position fermée et la mémoire résistive 708 commute de son état de haute résistance vers son état de basse résistance. La tension Vout doit donc être adaptée pour que le transistor Q1 passe en position fermée lorsqu'elle lui est appliquée, c'est-à-dire dès que le neurone est déclenché et qu'il génère une impulsion de sortie. L'impulsion de contrôle 720 de tension Vout peut être identique à l'impulsion de sortie 711, mais un autre type de signal peut également être généré de manière à ce qu'il fasse commuter le transistor Q1 au moment du déclenchement du neurone.

Avant chaque déclenchement du neurone, la mémoire résistive doit être réinitialisée dans son état de haute résistance. Dans un mode de réalisation, cette réinitialisation est effectuée dès que l'émission d'une impulsion de sortie est terminée.

Dans cet exemple, la mémoire résistive est de type bipolaire. Ainsi, l'opération de réinitialisation peut être effectuée à l'aide de deux transistors Q2, Q3 et d'un bloc de retard 704. Après que la mémoire résistive soit passée dans son état bas de résistance, l'élément de retard 704 produit une impulsion retardée de tension par exemple égale à Vout en entrée de Q2 et Q3. Le transistor Q2 est positionné de manière à relier l'anode de la mémoire résistive à la masse 721 lorsque celui jour le rôle d'un interrupteur en position fermée. Le transistor Q3 est positionné de manière à relier la cathode de la mémoire résistive à la sortie du générateur de retard 704 de manière à ce que l'impulsion de sortie générée en sortie dudit générateur soit appliquée à la cathode de la mémoire résistive. Le transistor Q3 peut être remplacé par une ligne reliant directement une sortie du générateur de retard 704 à la cathode de la mémoire résistive.

Ce mécanisme permet d'inverser la polarité aux bornes de la mémoire résistive. En effet, lorsque Q1 passe en position ouverte, la tension augmente sur la cathode de la mémoire résistive CBRAM. Cela se traduit par une chute de tension et la commutation de la mémoire résistive dans son état de haute résistance. L'impulsion nécessaire pour réinitialiser la mémoire résistive CBRAM peut être choisie plus courte que l'intervalle minimum entre deux impulsions d'entrée de manière à assurer que tous les signaux d'entrée seront pris en compte par l'intégrateur.

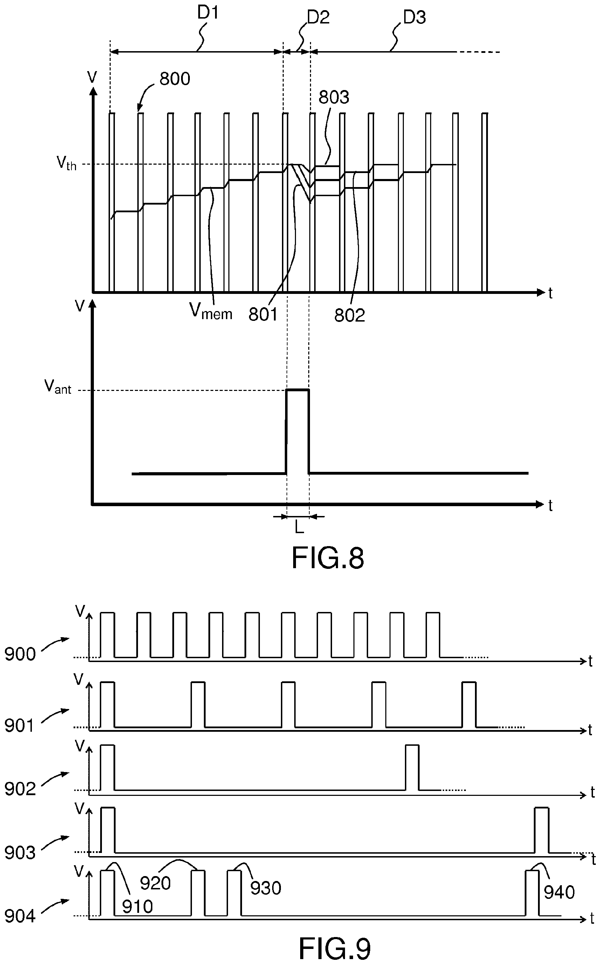

La figure 8 illustre le fonctionnement stochastique d'un neurone S-LIF. La courbe du haut représente les évolutions de la tension Vmem et la courbe du bas représente la tension appliquée au niveau de la grille du transistor Q1.

Dans cet exemple, un signal d'entrée correspondant à une succession d'impulsions 800 est utilisé. Une première phase D1 de fonctionnement est illustrée. Durant cette phase, Q1 joue le rôle d'un interrupteur en position ouverte. Ainsi, le condensateur Cmem se charge et la tension Vmem augmente lorsqu'une impulsion de signal 800 est présente en entrée du neurone.

Dans une deuxième phase D2 appelée aussi cycle de décharge, la grille du transistor Q1 est activée à l'aide d'une impulsion de contrôle de tension Vout. Q1 joue alors le rôle d'un interrupteur en position fermée. La mémoire résistive CBRAM 708 passe alors de l'état de haute résistance à l'état de basse résistance. En effet, la tension Vmem est appliquée à l'anode de la CBRAM et une opération de SET de la mémoire résistive est activée. Dans la suite de la description, une opération dite de SET correspond à la commutation de la mémoire résistive d'un état de haute résistance haut à un état de basse résistance et une opération dite de RESET correspond à la commutation de la mémoire résistive d'un état de basse résistance à un état de haute résistance.

La faible résistance de la mémoire résistive 708 induite par l'opération de SET ainsi que la position fermée de l'interrupteur Q1 permet au courant de circuler vers la masse 721. Cela a pour conséquence de faire baisser de la tension Vmem et de décharger le condensateur Cmem.

La diminution de la tension Vmem peut être estimée en calculant la durée totale pendant laquelle le courant circule à travers la CBRAM commutée. Cette durée correspond à la différence entre la largeur L de l'impulsion de contrôle et le temps Tset requis par la CBRAM pour passer à l'état de basse résistance. Comme la valeur de Tset pour les mémoires résistives ne sont pas constantes et suivent une distribution statistique (Figure 6c), le comportement de ce neurone artificiel n'est pas déterministe. La variation statistique du temps Tset est due à des facteurs physiques tels que la dissolution du filament à l'intérieur de la mémoire comme illustré précédemment (Figure 6b). Il est à noter que ce type de phénomène se produit également notamment pour les mémoires résistives de type CBRAM, PMC, EMC, PCM, OXRAM, MRAM ou STT-RAM.

Les variations de la durée Tset ont pour conséquence de faire varier le temps de décharge lorsqu'une impulsion de contrôle est émise. Ainsi, en fonction de la valeur réelle de Tset au moment de la commutation de la mémoire CBRAM, des durées de charge différentes seront requises avant que l'émission du pic de sortie suivant ne soit déclenchée. Cela signifie que pour le cycle de décharge suivant, l'état initial de la capacité de membrane sera différent. En conséquence, la quantité de courant entrant est variable pour charger Vmem au niveau de Vth entre deux cycles de déclenchement du neurone. Ainsi le caractère aléatoire du temps Tset permet un fonctionnement stochastique du neurone, c'est-à-dire non déterministe. Afin d'illustrer ce phénomène, trois courbes associées à des durées Tset différentes ont été représentées 801, 802, 803.

La figure 9 comprend cinq courbes présentant chacune une succession d'impulsions de sortie d'un neurone artificiel.

Comme pour la figure 8, le signal d'entrée choisi correspond à une succession d'impulsions, deux impulsions successives étant espacées d'un intervalle constant.

La courbe 900 représente le signal de sortie d'un neurone artificiel dans lequel la valeur de Tset est fixe et se situe dans la partie droite de la distribution présentée sur la figure 6c. Cela correspond au cas où le temps de passage de l'état haut vers l'état bas de résistance est important. Ainsi, la capacité Cmem se décharge peu pendant la durée l'impulsion de sortie et la tension Vmem atteint rapidement le seuil Vth. En conséquence, le signal de sortie correspond à une succession d'impulsions émises à fréquence élevée.

La courbe 901 représente également le signal de sortie d'un neurone artificiel S-LIF mais avec une valeur Tset fixe se situant au centre de la distribution représentée figure 6c. La valeur de Tset est donc plus importante que celle choisie pour obtenir la courbe 900. En conséquence, la fréquence d'émission des impulsions de sortie est moins importante. La courbe 902 suit le même principe et correspond au cas où la valeur de Tset est prise dans la partie gauche de la distribution représentée figure 6c.

La courbe 903 correspond au cas d'un neurone artificiel de type LIF. Quand un tel neurone se déclenche, la capacité Cmem est entièrement déchargée et la tension Vmem s'annule. Le temps de charge pour que le neurone émette à nouveau une nouvelle impulsion de sortie est alors maximum.

La courbe 904 correspond au cas réel d'un neurone artificiel de type S-LIF. A la différence des résultats obtenus avec les courbes 900, 901 et 902 pour lesquelles une valeur constante de Tset était choisie, ici cette valeur peut varier d'un déclenchement à l'autre du neurone.

Dans cet exemple, une première impulsion de sortie 910 est émise suivie d'une deuxième impulsion 920. L'espacement entre ces deux impulsions est la conséquence d'une valeur de Tset égale à celle utilisée pour générer la courbe 901. Ensuite, la deuxième impulsion de sortie 920 est émise suivie d'une troisième impulsion 930. L'espacement entre ces deux impulsions est la conséquence d'une valeur de Tset égale à celle utilisée pour générer la courbe 900. La troisième impulsion de sortie 930 est émise suivie d'une quatrième impulsion 940. L'espacement entre ces deux impulsions est la conséquence d'une valeur de Tset égale à celle utilisée pour générer la courbe 902.

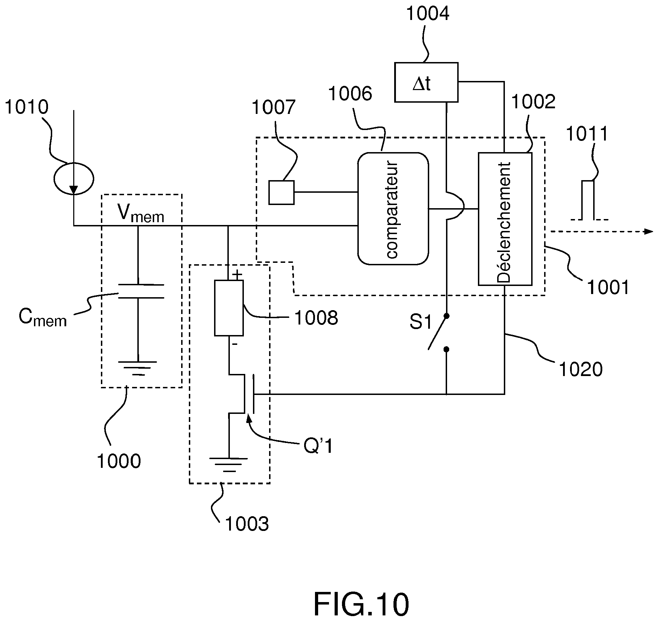

La figure 10 représente un exemple de circuit, sur lequel les revendications ne portent pas, et mettant en œuvre un neurone artificiel de type S-LIF utilisant une mémoire résistive unipolaire.

Comme pour le cas du circuit illustré à l'aide de la figure 7, l'architecture présentée se compose de plusieurs blocs fonctionnels. Certains blocs peuvent se retrouver dans des architectures de neurones artificiels classiques de type LIF. Une source de courant 1010 est représentée et correspond au courant d'entrée injecté par le réseau synaptique dans le neurone artificiel. Le circuit comprend également un bloc d'intégration 1000 composé d'un condensateur Cmem relié à la masse. Un bloc 1001 joue le même rôle que le bloc 402. Il peut être mis en œuvre par exemple à l'aide d'un comparateur de tensions 1006. La tension Vmem de sortie du bloc d'intégration 1000 est comparée avec une tension seuil Vth. La tension seuil Vth peut-être générée par un générateur de tension 1007. Le comparateur 1006 génère un signal de déclenchement lorsque la tension Vmem dépasse la tension seuil Vth. Ledit signal est transmis à un générateur d'impulsion de sortie 1002 qui produit une impulsion de sortie 1011 à chaque fois que le signal de déclenchement est transmis avec par exemple l'état 1. Cette impulsion de sortie peut être ensuite injectée dans une couche de synapse d'un système neuromorphique. Le circuit comprend également un bloc 1003 composé d'une mémoire résistive 1008 et d'un transistor Q'1.

La mémoire résistive 1008 est reliée à la ligne de tension Vmem d'une part et au transistor Q'1 d'autre part.

Dans cet exemple, la mémoire résistive est de type unipolaire. Un commutateur S1 pouvant être commandé par l'élément de retard 1004 suffit à réinitialiser la mémoire résistive dans son état de haute résistance suite au déclenchement du neurone.

Ce mode de réalisation a pour avantage d'être simple à mettre en œuvre. En effet, l'utilisation de transistors supplémentaires tels que Q2 et Q3 n'est plus nécessaire.

## Revendications

1. Circuit pour la mise en œuvre d'un neurone artificiel, ledit circuit comprenant :
- un intégrateur (401, 700, 1000) configuré pour intégrer une impulsion de courant d'entrée du neurone (400, 710, 1010) de manière à produire en sortie un signal de tension Vmem ;
- un générateur de signaux (402, 701, 1001) relié à la sortie de l'intégrateur, présentant une première et une deuxième sortie et configuré pour produire, lorsque la tension Vmem est supérieure ou égale à une tension Vth prédéterminée (707, 1007), un premier signal sur sa première sortie, correspondant à une impulsion de courant de sortie du neurone (711, 1011), et un deuxième signal sur sa deuxième sortie, correspondant à une impulsion de tension de contrôle (720) Vout ;
- une mémoire résistive (708, 1008) comprenant deux bornes et apte à commuter d'un état de haute résistance vers un état de basse résistance en un temps Tset non déterministe, suivant une distribution statistique propre à ladite mémoire, une première borne étant reliée à la sortie de l'intégrateur (401, 700, 1000) ;
- un transistor (Q1, Q'1) présentant une première borne reliée à une branche de potentiel nul, une deuxième borne reliée à une deuxième borne de la mémoire résistive (708, 1008) et une borne de commande reliée à la deuxième sortie du générateur de signal, ledit transistor étant en outre configuré pour être contrôlé par le deuxième signal (720, 1020) de sortie du générateur de signaux (701, 1001) de manière à ce qu'en présence de l'impulsion de tension de contrôle Vout la deuxième borne de la mémoire résistive soit reliée, par l'intermédiaire dudit transistor, à la branche de potentiel nul, de telle sorte que la mémoire résistive commute de son état de haute résistance vers son état de basse résistance, cette commutation ayant pour effet de faire baisser la tension Vmem ;
- un générateur de retard (704) relié à la première sortie du générateur de signaux et adapté pour produire une impulsion retardée de tension lorsque la mémoire résistive commute de son état de haute résistance vers son état de basse résistance ;
- un deuxième transistor (Q2) présentant une première borne connectée à la branche de potentiel nul, une deuxième borne connectée à la première borne de la mémoire résistive et une borne de commande reliée audit générateur de retard de sorte que la première borne de la mémoire résistive soit reliée à la branche de potentiel nul lorsque la mémoire résistive commute de son état de haute résistance vers son état de basse résistance ;
- une connexion reliant la deuxième borne de la mémoire résistive audit générateur de retard de sorte que ladite impulsion retardée de tension soit appliquée à la deuxième borne de la mémoire résistive de manière à faire commuter la mémoire résistive de son état de basse résistance vers son état de haute résistance, après ladite commutation de l'état de haute résistance vers l'état de basse résistance.

2. Circuit selon la revendication 1 dans lequel la mémoire résistive (708, 1008) est choisie parmi les technologies suivantes : CBRAM, PMC, EMC, PCM, OXRAM, MRAM, STT-RAM.

3. Circuit selon l'une des revendications précédentes dans lequel le transistor Q1 est de type MOSFET.

4. Circuit selon l'une des revendications précédentes dans lequel la mémoire résistive est configurée pour commuter de son état de basse résistance vers son état de haute résistance dès que l'émission d'une impulsion de courant de sortie du neurone est terminée.

5. Circuit selon l'une des revendications précédentes dans lequel l'intégrateur (700, 1000) est mis en œuvre par une capacité (Cmem) reliée à la branche de potentiel nul.

6. Circuit selon l'une des revendications précédentes dans lequel la mémoire résistive est bipolaire.

7. Système neuromorphique comprenant un ensemble d'au moins un neurone d'entrée, un ensemble d'au moins un neurone de sortie et un réseau de synaptique, ledit réseau synaptique reliant les neurones d'entrées aux neurones de sorties, l'ensemble d'au moins un neurone d'entrée et/ou l'ensemble d'au moins un neurone de sortie étant mis en œuvre par au moins un circuit selon l'un des revendications précédentes.

## Patentansprüche

1. Schaltung zum Implementieren eines künstlichen Neurons, wobei die Schaltung Folgendes umfasst:
- einen Integrator (401, 700, 1000), der zum Integrieren eines Eingangsstromimpulses des Neurons (400, 710, 1010) konfiguriert ist, um am Ausgang ein Spannungssignal Vmem zu erzeugen;
- einen Signalgenerator (402, 701, 1001), der mit dem Ausgang des Integrators verbunden ist, einen ersten und einen zweiten Ausgang hat und zum Produzieren, wenn die Spannung Vmem größer als oder genauso groß wie eine vorbestimmte Spannung Vth (707, 1007) ist, eines ersten Signals entsprechend einem Ausgangsstromimpuls des Neurons (711, 1011) an seinem ersten Ausgang und eines zweiten Signals entsprechend einem Steuerspannungsimpuls (720) Vout an seinem zweiten Ausgang konfiguriert ist;
- einen resistiven Speicher (708, 1008) der zwei Anschlüsse umfasst und dazu geeignet ist, innerhalb einer nicht deterministischen Zeit Tset von einem hochohmigen Zustand in einen niederohmigen Zustand zu schalten, wobei er einer dem Speicher eigenen statistischen Verteilung folgt, wobei ein erster Anschluss mit dem Ausgang des Integrators (401, 700, 1000) verbunden ist;
- einen Transistor (Q1, Q'1) der einen ersten Anschluss, der mit einem Nullpotentialzweig verbunden ist, einen zweiten Anschluss, der mit einem zweiten Anschluss des resistiven Speichers (708, 1008) verbunden ist, und einen Steueranschluss, der mit dem zweiten Ausgang des Signalgenerators verbunden ist, aufweist, wobei der Transistor ferner konfiguriert ist, um durch das zweite Ausgangssignal (720, 1020) des Signalgenerators (701, 1001) gesteuert zu werden, so dass bei Vorliegen des Steuerspannungsimpulses Vout der zweite Anschluss des resistiven Speichers über den Transistor mit dem Nullpotentialzweig verbunden wird, so dass der resistive Speicher von seinem hochohmigen Zustand in seinen niederohmigen Zustand schaltet, wobei dieses Schalten das Senken der Spannung Vmem bewirkt;
- einen Verzögerungsgenerator (704), der mit dem ersten Ausgang des Signalgenerators verbunden und zum Produzieren eines verzögerten Spannungsimpulses ausgelegt ist, wenn der resistive Speicher von seinem hochohmigen Zustand in seinen niederohmigen Zustand schaltet;
- einen zweiten Transistor (Q2), der einen ersten Anschluss, der mit dem Nullpotentialzweig verbunden ist, einen zweiten Anschluss, der mit dem ersten Anschluss des resistiven Speichers verbunden ist, und einen Steueranschluss, der mit dem Verzögerungsgenerator verbunden ist, aufweist, so dass der erste Anschluss des resistiven Speichers mit dem Nullpotentialzweig verbunden ist, wenn der resistive Speicher von seinem hochohmigen Zustand in seinen niederohmigen Zustand schaltet;
- eine Verbindung, die den zweiten Anschluss des resistiven Speichers mit dem Verzögerungsgenerator verbindet, so dass der verzögerte Spannungsimpuls an den zweiten Anschluss des resistiven Speichers derart angelegt wird, dass der resistive Speicher nach dem Schalten vom hochohmigen in den niederohmigen Zustand von seinem niederohmigen Zustand in seinen hochohmigen Zustand geschaltet wird.

2. Schaltung nach Anspruch 1, wobei der resistive Speicher (708, 1008) aus den folgenden Technologien ausgewählt ist: CBRAM, PMC, EMC, PCM, OXRAM, MRAM, STT-RAM

3. Schaltung nach einem der vorherigen Ansprüche, wobei der Transistor Q1 vom MOSFET-Typ ist.

4. Schaltung nach einem der vorherigen Ansprüche, wobei der resistive Speicher zum Schalten von seinem niederohmigen Zustand in seinen hochohmigen Zustand konfiguriert ist, sobald das Senden eines Ausgangsstromimpulses des Neurons beendet ist.

5. Schaltung nach einem der vorherigen Ansprüche, wobei der Integrator (700, 1000) durch eine mit dem Nullpotentialzweig verbundene Kapazität (Cmem) implementiert wird.

6. Schaltung nach einem der vorherigen Ansprüche, wobei der resistive Speicher bipolar ist.

7. Neuromorphes System, das einen Satz von mindestens einem Eingangsneuron, einen Satz von mindestens einem Ausgangsneuron und ein synaptisches Netzwerk umfasst, wobei das synaptische Netzwerk die Eingangsneuronen mit den Ausgangsneuronen verbindet, wobei der Satz von mindestens einem Eingangsneuron und/oder der Satz von mindestens einem Ausgangsneuron durch mindestens eine Schaltung nach einem der vorherigen Ansprüche implementiert ist.

## Claims

1. A circuit for implementing an artificial neuron, said circuit comprising:
- an integrator (401, 700, 1000) configured to integrate an input current pulse of the neuron (400, 710, 1010) so as to output a Vmem voltage signal;
- a signal generator (402, 701, 1001) linked to the output of the integrator, having a first and a second output and configured to produce, when the voltage Vmem is higher than or equal to a predetermined voltage Vth (707, 1007), a first signal on its first output, corresponding to an output current pulse of the neuron (711, 1011), and a second signal on its second output, corresponding to a control voltage pulse Vout (720);
- a resistive memory (708, 1008) comprising two terminals and able to switch from a high resistance state to a low resistance state in a non-deterministic period of time Tset, following a statistical distribution specific to said memory, a first terminal being linked to the output of the integrator (401, 700, 1000);
- a transistor (Q1, Q'1) having a first terminal linked to a branch at zero potential, a second terminal linked to a second terminal of the resistive memory (708, 1008) and a control terminal linked to the second output of the signal generator, said transistor being further configured to be controlled by the second output signal (720, 1020) of the signal generator (701, 1001) such that in the presence of the control voltage pulse Vout, the second terminal of the resistive memory is linked, through said transistor, to the branch at zero potential, such that the resistive memory switches from its high resistance state to its low resistance state, this switch having the effect of lowering the voltage Vmem;
- a delay generator (704) linked to the first output of the signal generator and adapted to produce a delayed voltage pulse when the resistive memory switches from its high resistance state to its low resistance state;
- a second transistor (Q2) having a first terminal linked to a branch at zero potential, a second terminal linked to the first terminal of the resistive memory and a control terminal linked to said delay generator such that the first terminal of the resistive memory is linked to the branch at zero potential when the resistive memory switches from its high resistance state to its low resistance state;
- a connection linking the second terminal of the resistive memory to said delay generator such that said delayed voltage pulse is applied to the second terminal of the resistive memory in such a manner as to make the resistive memory switch from its low resistance state to its high resistance state, after said switch from the high resistance state to the low resistance state.

2. The circuit according to claim 1, wherein the resistive memory (708, 1008) is chosen from among the following technologies: CBRAM, PMC, EMC, PCM, OXRAM, MRAM, STT-RAM

3. The circuit according to one of the preceding claims, wherein the transistor Q1 is of MOSFET type.

4. The circuit according to one of the preceding claims, wherein the resistive memory is configured to switch from its low resistance state to its high resistance state as soon as the emission of an output current pulse of the neuron is terminated.

5. The circuit according to one of the preceding claims, wherein the integrator (700, 1000) is implemented by a capacitance (Cmem) linked to the branch at zero potential.

6. The circuit according to one of the preceding claims, wherein the resistive memory is bipolar.

7. A neuromorphic system comprising a set of at least one input neuron, a set of at least one output neuron, and a synaptic network, said synaptic network linking the input neurons to the output neurons, the set of at least one input neuron and/or the set of at least one output neuron being implemented by at least one circuit according to one of the preceding claims.
